Europäisches Patentamt

European Patent Office

Office européen des brevets

(19)

(11) Numéro de publication: **0 075 351**
**A1**

# (12) DEMANDE DE BREVET EUROPEEN

(21) Numéro de dépôt: **82201102.9**

(22) Date de dépôt: **07.09.82**

(51) Int. Cl.³: **G 06 K 19/06, H 01 L 23/54**

(30) Priorité: **11.09.81 FR 8117231**

(43) Date de publication de la demande: **30.03.83**
**Bulletin 83/13**

(84) Etats contractants désignés: **CH DE FR GB IT LI SE**

(71) Demandeur: **R.T.C. LA RADIOTECHNIQUE-COMPELEC**
**Société anonyme dite:, 51 rue Carnot BP 301,**
**F-92156 Suresnes (FR)**

(84) Etats contractants désignés: **FR**

(71) Demandeur: **N.V. Philips' Gloeilampenfabrieken,**
**Groenewoudseweg 1, NL-5621 BA Eindhoven (NL)**

(84) Etats contractants désignés: **CH DE GB IT LI SE**

(72) Inventeur: **Parmentier, Paul, Société Civile**
**S.P.I.D. 209 rue de l'Université, F-75007 Paris (FR)**

(74) Mandataire: **Pinchon, Pierre et al, Société Civile**
**S.P.I.D. 209 rue de L'Université, F-75007 Paris (FR)**

(54) **Procédé pour fabriquer une carte d'identification et carte d'identification produite, par exemple au moyen de ce procédé.**

(57) Carte d'identification comportant un circuit semiconducteur intégré (13) qui est fixé sur un support auxiliaire (11) et qui est connecté électriquement à des trajets métallisés (3, 5) sur les deux faces du support auxiliaire (11). Le support auxiliaire (11) est logé avec le circuit semiconducteur intégré (13) dans un support principal (29). Le support auxiliaire (11) est pourvu d'un trou métallisé (7) qui est, en partie, supprimé par la formation d'un cavité (15) dans le support auxiliaire (11) dans laquelle le circuit semiconducteur (13) est logé. Le circuit semiconducteur (13) est connecté électriquement par des fils de connexion (23, 25) au premier trajet métallisé (3) sur le support auxiliaire (11) et au moyen d'une colle conductrice électrique (21) et du revêtement métallique (18) du reste (17) du trou métallisé (7) à l'autre trajet métallisé (5) sur le support auxiliaire (11).

La carte d'identification peut être utilisée partout où une identification de personnes ou d'objets est nécessaire, comme par exemple pour des paiements ou pour le contrôle de la qualité de produits pendant le procédé de fabrication.

Procédé pour fabriquer une carte d'identification et carte d'identification produite, par exemple au moyen de ce procédé.

La présente invention concerne un procédé pour fabriquer une carte d'identification électronique selon lequel on crée des contacts électriques sur les deux faces d'un circuit semiconducteur intégré, contact le reliant à des trajets métallisés sur au moins une face d'un support auxiliaire, ce dernier et le circuit intégré étant ensuite montés ensemble dans un support principal, le circuit intégré étant enrobé dans une masse de matière électriquement isolante qui remplit une cavité dans l'un desdits supports.

L'invention a trait également à une carte d'identification comprenant un circuit semiconducteur intégré dont chacune des deux faces est électriquement reliée à des trajets métallisés disposés sur au moins une face d'un support auxiliaire qui supporte le circuit intégré et est monté dans un support principal, le circuit intégré étant enrobé dans un matériau isolant qui remplit une cavité dans l'un desdits supports.

Dans un procédé connu et dans une carte d'identification connue (décrite dans le brevet français N° 2.439.438) du type spécifié, le circuit intégré fixé sur le support auxiliaire est logé dans une cavité du support principal. Un inconvénient d'une cavité relativement profonde dans le support principal est que la charge mécanique du support principal lors des flexions multiples qui se présentent dans la pratique peut être appréciable. On tend, par conséquent, à rendre aussi petite que possible la profondeur de la cavité dans le support principal par rapport à l'épaisseur totale du support principal tandis que l'épaisseur totale reste aussi en déçà d'une valeur maximale standard. De plus, pour augmenter la fiabilité et pour obtenir une carte relativement peu coûteuse, on souhaite utiliser autant que possible des techniques adoptées à grande échelle et autant que possible des composants
standards.

L'invention a pour but de procurer un procédé pour fabriquer une carte d'identification et une carte
d'identification permettant d'éviter l'inconvénient précité et de respecter autant que possible la tendance précitée.

Le procédé pour fabriquer une carte d'identification conforme à l'invention est caractérisé en ce
qu'on munit le support auxiliaire, qui comporte des trajets métallisés sur ses deux faces, d'au moins un trou
métallisé, on forme ensuite la cavité à l'endroit où est
situé le trou métallisé, ladite cavité débouchant dans ce
qui reste du trou métallisé, après la formation de la cavité, on dispose ensuite le circuit intégré dans la cavité
en reliant électriquement une de ses faces aux trajets métallisés situés sur une face du support auxiliaire au moyen
d'une colle conductrice disposée de façon à déborder dans
le trou métallisé et via le métal du trou métallisé,
l'autre face du circuit intégré étant ensuite connectée
aux trajets métallisés de l'autre face du support auxiliaire.

Une carte d'identification conforme à l'invention est caractérisée en ce que le support auxiliaire
qui est muni de trajets métallisés sur ses deux faces comporte au moins un trou métallisé dans lequel débouche une
cavité du support auxiliaire, le circuit intégré étant
situé dans la cavité et une de ses faces étant connectée
aux trajets métallisés sur une face du support auxiliaire
tandis que son autre face est connectée aux trajets métallisés sur l'autre face du support auxiliaire au moyen
d'une colle conductrice et via le métal du trou métallisé.

Il convient de noter que le brevet des
Etats-Unis d'Amérique N° 3.934.336 décrit un procédé pour
la connexion électrique des deux faces d'un circuit intégré à un trajet métallisé placé sur un substrat. Le circuit
intégré se trouve dans une cavité du substrat.

L'invention sera expliquée plus en détail ci-après avec référence au dessin annexé dans lequel:

la Figure 1A est une vue en coupe d'un support auxiliaire utilisé dans une carte d'identification conforme à l'invention;

la Figure 1B est une vue en coupe du support auxiliaire représenté sur la Figure 1A dans lequel une cavité destinée à un circuit intégré est ménagée et qui est pourvu d'un cadre;

la Figure 1C est une vue en coupe du support auxiliaire r présenté sur la Figure 1B, dans la cavité duquel est logé un circuit intégré enrobé d'une matière électriquement isolante;

La Figure 2 illustre une carte d'identification conforme à l'invention.

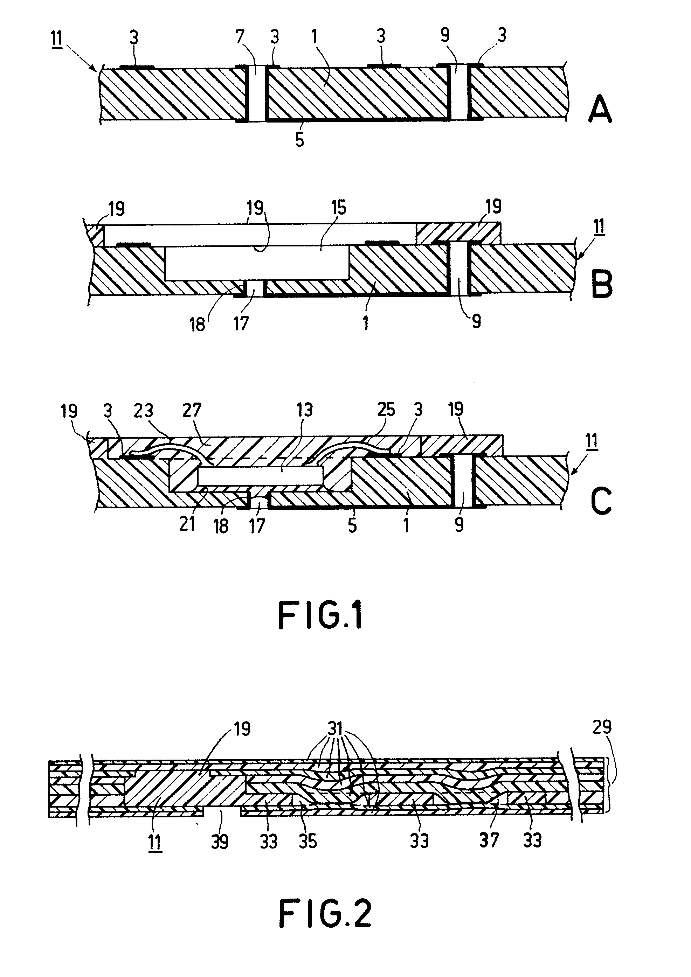

Le substrat électriquement isolant 1 représenté sur la Figure 1A est pourvu sur l'une de ses faces de trajets métallisés 3 et sur son autre face de trajets métallisés 5. Les connexions électriques entre les trajets métallisés 3 et 5 sont formées par un certain nombre de trous métallisés 7 et 9. Le substrat 1 avec ses trajets métallisés 3 et 5 est ledit support auxiliaire 11 pour un circuit semiconducteu intégré 13 (voir Figure 1C). Un support présentant un circuit imprimé et des trous métallisés est de préférence utilisé comme support auxiliaire 11 d'un type courant, comme par exemple un substrat en papier fort ou en résine époxyde renforcée par des fibres de verre et présentant des trajets métallisés produits par des techniques soustractives et/ou additives.

Le support auxiliaire 11 est pourvu, à l'endroit du trou métallisé 7, d'une cavité 15 de dimensions suffisamment grandes pour pouvoir contenir le circuit intégré 13 (voir Figure 1A et 1B). La cavité 15 a une profondeur telle qu'une partie 17 du trou métallisé 7 subsiste. Ceci est essentiel pour une carte d'identification conforme à l'invention. Ensuite, un cadre plat fermé (non visible sur la Figure 1B) est appliqué sur la face supérieure du substrat 1. Le cadre 19 est de préférence formé par collage d'une couche photosensible qui est durcie par une exposition locale à la lumière et dont la partie non exposée est éliminée par morsure. A cet effet, on utilise la même matière photosensiblr que celle qui est utilisée pour la fabrication des trajets métallisés 3 et 5. Après la formation de la cavité 15, le circuit intégré 13 est fixé, par exemple à l'aide d'une colle ou d'une pâte conductrice électrique 21 (voir Figure 1C) sur le fond de la cavité 15. La quantité de colle 21 est choisie telle que la colle remplisse partiellement la partie restante 17 du trou métallisé 7. Le contact électrique avec les trajets métallisés 5 s'effectue, par conséquent, par l'intermédiaire du revêtement métallique 13 de la partie restante 17 du trou métallisé 7. Le circuit intégré 13 est d'un type qui comporte des connexions électriques (électrodes) des deux côtés. Dans le cas présent, les connexions dites actives se trouvent sur la face supérieure du circuit intégré tandis que la connexion dite de masse se trouve sur sa face inférieure.

Après avoir établi la connexion de masse au moyen de la colle 21, à la face supérieure du circuit intégré 13, on connecte des fils de connexion 23 et 25 électriquement d'une manière courante aux électrodes actives du circuit et aux trajets métallisés 5 se trouvant sur la face supérieure du substrat 1. On remplit l'espace qui est entouré par le cadre 19 d'une cire 27 en matière isolante. Après durcissement de la cire 27, le circuit intégré 13 ainsi que les fils de connexion 23 et 25 sont ancrés solidement au substrat 1. L'épaisseur du cadre 19 est choisie telle que les fils de connexion 23 et 25 soient entièrement recouverts par la cire 27. Le cadre 19 non seulement détermine l'épaisseur de la couche de cire, mais aussi empêche que la cire 27 s'écoule, par exemple, dans le trou métallisé 9 voisin de la cavité 15.

Le support auxiliaire 11 est ensuite placé, en compagnie du circuit intégré 13 qui y est ancré, dans un support principal 29 qui est formé par plusieurs bandes 31 de matière thermoplastique isolante électrique. Le circuit intégré se trouve entre un certain nombre de bandes 31 de matière thermoplastique qui
sont comprimées à chaud en un stratifié. Le support auxiliaire 11 est pourvu d'une partie saillante 33 plus mince
dans laquelle sont ménagées des ouvertures 35 et 37. La
partie 33 peut, à l'aide d'une machine adéquate, être formée dans le support secondaire en même temps que la cavité
15. Pendant leur compression à chaud en un support principal 29, les bandes 31 sont stratifiées. De plus, la matière
des bandes s'écoule des deux côtés dans les ouvertures 35
et 37 de sorte qu'un accrochage de la matière des bandes
se produit à travers les ouvertures 35 et 37. Le support
auxiliaire 11 est ainsi ancré dans le support principal 29.
Les deux bandes inférieures 31 représentées sur la Figure 2
présentent une ouverture 39 par laquelle un contact électrique peut être établi avec le circuit intégré.

         Dans le cas présent, les bandes 31 sont en
poly(chlorure de vinyle). On utilise huit bandes présentant
(du haut vers le bas) les épaisseurs respectives suivantes:
100, 100, 100, 100, 200, 200, 100 et 60 micromètres.
l'épaisseur totale de 960 micromètres du support principal
29 est réduite, après la compression à chaud, à 760 micromètres et satisfait ainsi à l'exigence standard des cartes
d'identification en ce qui concerne l'épaisseur.

         Les étapes de fabrication décrites plus
haut sont par elles-mêmes en usage à grande échelle dans
la fabrication en masse principalement de composants électroniques et ont abouti à une fiabilité élevée et à un prix
de revient relativement bas. Les composants utilisés satisfont aussi à ces exigences. Pour la fabrication des substrats 1 et des bandes 21, on part de préférence de surfaces de matière relativement grandes de sorte qu'on peut
obtenir un grand nombre de substrats 1 et de bandes 11 au
cours d'une opération simultanée. Ceci assure une reproductibilité élevée et un faible taux de rebut. Le cadre 19
peut aussi être fabriqué d'une manière semblable simultanément pour un grand nombre de cartes d'identification.

         Selon l'application de la carte d'identification électronique, un ou plusieurs circuits intégrés

0075351

peuvent être placés dans le support auxiliaire 11. Il peut s'agir, par exemple de circuits de mémoire ou de circuits de traitement ainsi que de combinaisons de tels circuits. La carte peut ainsi, en fonction des données stockées dans un circuit de mémoire, servir exclusivement à identifier des personnes ou des objets, mais elle peut aussi être utilisée, en combinaison avec l'identification, d'une manière plus active comme carte de crédit permettant un enregistrement ou une lecture électronique. Quant à l'identification d'objets, on peut, par exemple imaginer le contrôle de qualité de produits pendant le procédé de fabrication.

REVENDICATIONS:

1.          Procédé pour fabriquer une carte d'identification électronique, selon lequel on crée des contacts
électriques sur les deux faces d'un circuit semiconducteur
intégré, contacts le reliant à des trajets métallisés sur
au moins une face d'un support auxiliaire, ce dernier et
le circuit intégré étant ensuite montés ensembles dans un
support principal, le circuit intégré étant enrobé dans
une masse de matière électriquement isolante qui remplit
une cavité dans l'un desdits supports, caractérisé en ce
qu'on munit le support auxiliaire (11), qui comporte des
trajets métallisés (3, 5) sur ses deux faces, d'au moins
un trou métallisé (7), on forme ensuite la cavité (15) à
l'endroit où est situé le trou métallisé (7), ladite cavité (15) débouchant dans ce qui reste du trou métallisé
(7, 17) après la formation de la cavité (15), on dispose
ensuite le circuit intégré (13) dans la cavité (15) en
reliant électriquement une de ses faces aux trajets métallisés (5) situés sur une face du support auxiliaire
(11) au moyen d'une colle conductrice (21) disposée de
façon à déborder dans le trou métallisé (17) et via le
métal (18) du trou métallisé (17), l'autre face du circuit
intégré (13) étant ensuite connectée aux  trajets métallisés (3) de l'autre face du support auxiliaire (11).

2.          Carte d'information électronique comprenant un circuit semiconducteur intégré dont chacune des
deux faces est électriquement reliée à des trajets métallisés disposés sur au moins une face d'un support auxiliaire qui supporte le circuit intégré et est monté dans
un support principal, le circuit intégré étant enrobé
dans un matériau isolant qui remplit une cavité dans l'un
desdits supports, caractérisée en ce que le support auxiliaire (11) qui est muni de trajets métallisés (3, 5) sur
ses deux faces, comporte au moins un trou (7, 17) métallisé dans lequel débouche une cavité (15) du support auxiliaire (11), le circuit intégré (13) étant situé dans la
cavité (15) et une de ses faces étant reliée aux trajets
métallisés (3) sur une face du support auxiliaire (11),
tandis que son autre face est reliée aux trajets métallisés (5) sur l'autre face du support auxiliaire (11), au
moyen d'une colle conductrice (21) et via le métal (18)
du trou métallisé (17).

FIG.1

FIG.2

Office européen
des brevets

**RAPPORT DE RECHERCHE EUROPEENNE**

0075351
Numéro de la demande

EP 82 20 1102

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| | --- | | G 06 K 19/06 |
| Y | GB-A-2 026 234 (OHYAMA et al.) *Figures 1-6; page 2, ligne 67 - page 3, ligne 102* | 1,2 | H 01 L 23/54 |
| | --- | | |
| Y | FR-A-2 191 406 (IBM) *Figure 5; page 6, ligne 40 - page 7, ligne 20* | 1,2 | |
| | --- | | |
| Y | FR-A-2 439 438 (CII-HB) *Figures 5,6,8,9; page 8, ligne 3 - page 10, ligne 15* | 1,2 | |
| | ----- | | |

**DOMAINES TECHNIQUES RECHERCHES (Int. Cl. 3)**

G 06 K 19
H 01 L 23

Le présent rapport de recherche a été établi pour toutes les revendications

| Lieu de la recherche | Date d'achèvement de la recherche | Examinateur |
|---|---|---|
| LA HAYE | 22-12-1982 | FORLEN G.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82